# EUROPEAN PATENT SPECIFICATION

(11) **EP 2 784 829 B1**
(45) Date of publication and mention of the grant of the patent: **16.05.2018**
(21) Application number: 12852335.4
(22) Date of filing: 15.10.2012
(51) Int. Cl.: H01L 31/18, B23K 26/36, H01L 31/032, H01L 31/0224, H01L 31/0216, H01L 31/0392, H01L 31/02, H01L 31/0749

(54) **CIS/CIGS SOLAR CELL HAVING A REAR TCO LAYER AND PRODUCTION METHOD THEREFOR**
CIS/CIGS-SOLARZELLE MIT EINER HINTEREN TCO-SCHICHT UND HERSTELLUNGSVERFAHREN DAFÜR
CELLULE PHOTOVOLTAÏQUE CIS/CIGS COMPRENANT UNE COUCHE ARRIÈRE D'OCT ET PROCÉDÉ DE FABRICATION ASSOCIÉ

(30) Priority: 22.11.2011 KR 20110122499
(43) Date of publication of application: 01.10.2014
(73) Proprietor: Korea Institute of Energy Research, Daejeon 305-343 (KR)
(72) Inventor: EO, Young-Joo, Daejeon 305-509 (KR); YOON, Kyung-Hoon, Daejeon 305-340 (KR); GWAK, Jihye, Daejeon 302-120 (KR); YUN, Jae-Ho, Daejeon 301-150 (KR); AHN, Sejin, Daejeon 305-768 (KR); CHO, Ara, Seoul 151-050 (KR); SHIN, Kee-Shik, Daejeon 305-762 (KR); AHN, SeoungKyu, Daejeon 305-807 (KR)
(74) Representative: Franke, Dirk
(86) International application number: PCT/KR2012/008376
(87) International publication number: WO 2013/077547

(56) References cited:
- WO-A2-2010/114294
- KR-A- 20110 015 998
- KR-A- 20110 025 024
- KR-A- 20110 039 697
- US-A1- 2003 178 058
- US-A1- 2010 326 520

## Description

### Technical Field

The present invention relates to a CIS/CIGS-based solar cell including a rear TCO layer at the rear side thereof, which can increase a power generation efficiency by disposing a TCO layer and a buffer layer at the rear side thereof to increase the efficiency of a light-absorbing layer, and to a method of manufacturing the same.

### Background Art

Recently, due to the problems of serious environmental pollution and fossil energy resource exhaustion, the importance of development of next-generation clean energy sources has increased. Among the next-generation clean energy sources, a solar cell, which is a device for directly converting solar energy into electrical energy, is an energy source that is expected to solve future energy problems because it rarely causes environmental pollution, its energy resource is unrestricted, and its life span is semipermanent.

Solar cells are classified into various types according to the kind of materials used for a light-absorbing layer. Currently, among these solar cells, a silicon solar cell is generally used. However, the raw material consumption of the thin film-type solar cell is low because it is thin. Further, the thin film-type solar cell can be widely used because it is light. Research into amorphous silicon, Cd-Te, CIS and CIGS, as raw materials of such a thin film-type solar cell, is actively being conducted.

A CIS thin film or a CIGS thin film is one of I-III-VI compound semiconductors. Among experimentally-made thin film solar cells, a CIS thin film solar cell or a CIGS thin film solar cell exhibits the highest conversion efficiency. Particularly, since a CIS thin film solar cell or a CIGS thin film solar cell can be manufactured to a thickness of 10 µm or less and is stable even when it is used for a long period of time, it is considered as a high-efficiency solar cell that can be used in place of a silicon solar cell.

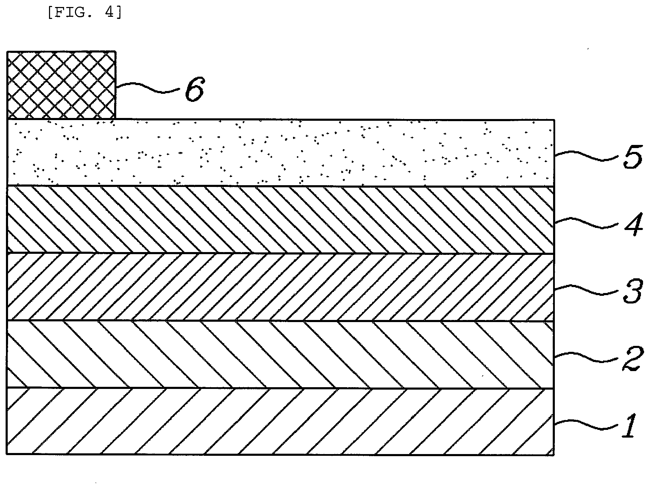

FIG. 4 shows the structure of a conventional CIS/CIGS-based solar cell employing the CIS or CIGS as a light-absorbing layer.

Referring to FIG. 4, the conventional CIS/CIGS-based solar cell including a substrate 1, a molybdenum (Mo) electrode 2, a light-absorbing layer 3, a buffer layer 4, a transparent conducting oxide (TCO) layer 5 and a metal electrode 6, which are sequentially layered from the bottom thereof.

The conventional CIS/CIGS-based solar cell is problematic in that the amount of light incident upon the light-absorbing layer 3 can be reduced due to the light absorption of the buffer layer 4 disposed on the light-absorbing layer 4. Further, the conventional CIS/CIGS-based solar cell is problematic in that its energy conversion efficiency is decreased because the metal electrode 6 is disposed on the TCO layer 5 in the form of a grid to reduce the amount of incident light with respect to the area thereof.

### Disclosure

### Technical Problem

Accordingly, the present invention has been devised to solve the above problems, and an object of the present invention is to provide a solar cell, in which a buffer layer and a TCO layer are disposed at the rear side of a light-absorbing layer, so the amount of light incident on the light-absorbing layer is increased, thereby increasing the energy conversion efficiency of the solar cell.

### Technical Solution

In order to accomplish the above object, an aspect of the present invention provides a CIS/CIGS-based solar cell, including: a substrate; first and second molybdenum electrodes disposed on the substrate at a predetermined interval in parallel with each other; a TCO layer disposed on upper and lateral sides of the second molybdenum electrode; a buffer layer disposed on upper and lateral sides of the TCO layer to compensate for a difference in bandgap between the TCO layer and a light-absorbing layer; the light-absorbing layer disposed on the first molybdenum electrode, the buffer layer and an area of the substrate partially opened between the first molybdenum electrode and the buffer layer; and an antireflection layer disposed on the light-absorbing layer to minimize the reflection of externally-applied light, wherein the light-absorbing layer is made of any one CIS/CIGS-based compound selected from the group consisting of Cu-In-Se, Cu-In-S, Cu-Ga-S, Cu-Ga-Se, Cu-In-Ga-Se, Cu-In-Ga-Se-(S,Se), Cu-In-Al-Ga-(S,Se) and Cu-In-Al-Ga-Se-S, or is made of any one CZTS-based compound selected from the group consisting of Cu-Zn-Sn-(Se,S) and Cu-In-Ga-Zn-Sn-(Se,S). The substrate may be made of any one selected from among glass, stainless steel and polyimide.

The TCO layer may include an N-type lower transparent conducting film and an I-type upper transparent conducting film.

The TCO layer may be made of zinc oxide or ITO.

The buffer layer may be made of any one selected from among cadmium sulfide, zinc sulfide and indium sulfide.

The antireflection layer may include a lower alumina layer in contact with the light-absorbing layer and an upper magnesium fluoride layer exposed to air.

Another aspect of the present invention provides a method of manufacturing a CIS/CIGS-based solar cell, including the steps of: a) providing a substrate; b) depositing a molybdenum layer on the substrate and then patterning the molybdenum layer to form first and second molybdenum electrodes disposed on the substrate at a predetermined interval in parallel with each other; c) depositing a TCO layer on the substrate having passed through the step b) and then patterning the TCO layer to form a TCO layer disposed on upper and lateral sides of the second molybdenum electrode; d) depositing a buffer layer on the substrate having passed through the step c) and then patterning the buffer layer to form a buffer layer disposed on upper and lateral sides of the TCO layer; e) forming a light-absorbing layer on the substrate having passed through the step d), wherein the light-absorbing layer is made of any one CIS/CIGS-based compound selected from the group consisting of Cu-In-Se, Cu-In-S, Cu-Ga-S, Cu-Ga-Se, Cu-In-Ga-Se, Cu-In-Ga-Se-(S,Se), Cu-In-Al-Ga-(S,Se) and Cu-In-Al-Ga-Se-S, or is made of any one CZTS-based compound selected from the group consisting of Cu-Zn-Sn-(Se,S) and Cu-In-Ga-Zn-Sn-(Se,S); and f) forming an antireflection layer on the light-absorbing layer.

The substrate may be made of any one selected from among glass, stainless steel and polyimide.

The substrate may be provided by sequentially washing it with acetone, methanol and distilled water and then ultrasonically treating it.

In the step b), the deposition of the molybdenum layer may be preformed by sputtering.

The deposition of the molybdenum layer using sputtering may be performed for 1 ∼ 30 minutes under the conditions of a power of 0.5 ∼ 50 kW, a sputtering pressure of 0.1 ∼ 50 m Torr and an argon (Ar) gas supply of 1 ∼ 100 sccm.

In the step b), the patterning of the molybdenum layer may be preformed by laser scribing.

The patterning of the molybdenum layer using laser scribing may be performed under the conditions of a laser wavelength of 300 ∼ 1100 nm and a laser power of 0.3 ∼ 3 W.

The TCO layer is made of zinc oxide or ITO.

In the step c), the deposition of the TCO layer may be preformed by sputtering.

In the step c), the patterning of the TCO layer may be preformed by laser scribing.

The patterning of the TCO layer using laser scribing may be performed under the conditions of a laser wavelength of 300 1100 nm and a laser power of 0.3 ∼ 3 W.

In the step c), the TCO layer is formed such a way that an N-type transparent conducting film may be deposited and patterned, and then an I-type transparent conducting film may be deposited and patterned to form a double TCO layer.

The N-type transparent conducting film and the I-type transparent conducting film may be deposited by sputtering, the deposition of the N-type transparent conducting film using sputtering may be performed for 10 ∼ 100 minutes under the conditions of a power of 50 ∼ 500 W, a sputtering pressure of 1 ∼ 50 m Torr, an argon gas supply of 10 ∼ 100 sccm and an oxygen gas supply of 0.5 ∼ 10 sccm, and the deposition of the I-type transparent conducting film using sputtering may be performed for 10 ∼ 100 minutes under the conditions of a power of 50 ∼ 500 W, a sputtering pressure of 1 ∼ 50 m Torr and an argon gas supply of 10 ∼ 100 sccm.

In the step d), the buffer layer may be made of any one selected from cadmium sulfide, zinc sulfide and indium sulfide.

In the step d), the buffer layer may be formed by immersing the substrate having passed through the step c) into a mixed solution including thiourea, cadmium sulfide and ammonia.

The buffer layer may be formed by immersing the substrate into the mixed solution at a temperature of 60 ∼ 100°C for 10 ∼ 100 minutes.

In the step d), the patterning of the buffer layer may be preformed by laser scribing.

The patterning of the buffer layer using laser scribing may be performed under the conditions of a laser wavelength of 300 ∼ 600 nm and a laser power of 0.3 ∼ 3 W.

In the step e), the formation of the light-absorbing layer may be preformed by non-vacuum coating or vacuum coating.

The non-vacuum coating may be any one selected from among spraying, ultrasonic spraying, spin coating, a doctor blade method, screen printing and ink-jet printing.

The vacuum coating is any one selected from among simultaneous vacuum evaporation, sputtering/selenization and three-stage simultaneous vacuum evaporation.

In the step f), the antireflection layer may be formed by sequentially forming a lower alumina layer and an upper magnesium fluoride layer.

The formation of the alumina layer may be performed by atomic layer deposition (ALD) using gas produced by the reaction of trimethyl aluminum and ozone.

The formation of the magnesium fluoride layer may be performed by thermal evaporation using magnesium fluoride pellets.

Still another aspect of the present invention provides a solar cell module comprising a CIS/CIGS solar cell, the CIS/CIGS solar cell includng: a substrate; first and second molybdenum electrodes disposed on the substrate at a predetermined interval in parallel with each other; a TCO layer disposed on upper and lateral sides of the second molybdenum electrode; a buffer layer disposed on upper and lateral sides of the TCO layer to compensate for a difference in bandgap between the TCO layer and a light-absorbing layer; the light-absorbing layer disposed on the first molybdenum electrode, the buffer layer and an area of the substrate partially opened between the first molybdenum electrode and the buffer layer; and an antireflection layer disposed on the light-absorbing layer to minimize the reflection of externally-applied light, wherein the light-absorbing layer is made of any one CIS/CIGS-based compound selected from the group consisting of Cu-In-Se, Cu-In-S, Cu-Ga-S, Cu-Ga-Se, Cu-In-Ga-Se, Cu-In-Ga-Se-(S,Se), Cu-In-Al-Ga-(S,Se) and Cu-In-Al-Ga-Se-S, or is made of any one CZTS-based compound selected from the group consisting of Cu-Zn-Sn-(Se,S) and Cu-In-Ga-Zn-Sn-(Se,S).

### Advantageous Effects

According to the solar cell of the present invention, a buffer layer and a TCO layer are disposed at the rear side of a light-absorbing layer to prevent the amount of light incident upon the light-absorbing layer from being reduced by removing the incident light obstruction structure disposed on the light-absorbing layer, so the amount of light incident upon the light-absorbing layer can be maximized, thereby increasing the energy conversion efficiency of the solar cell.

### Description of Drawings

FIG. 1 is a side sectional view showing the structure of a CIS/CIGS-based solar cell including a TCO layer at the rear side thereof according to the present invention.
FIG. 2 is a flowchart showing a method of manufacturing a CIS/CIGS-based solar cell including a TCO layer at the rear side thereof according to the present invention.
FIG. 3 is a schematic view showing a process of manufacturing a CIS/CIGS-based solar cell including a TCO layer at the rear side thereof according to the present invention.
FIG. 4 is a side sectional view showing the structure of a conventional CIS/CIGS-based solar cell.

### Best Mode

First, a CIS/CIGS-based solar cell including a TCO layer at the rear side thereof according to an embodiment of the present invention will be described, and then a method of manufacturing the same will be described.

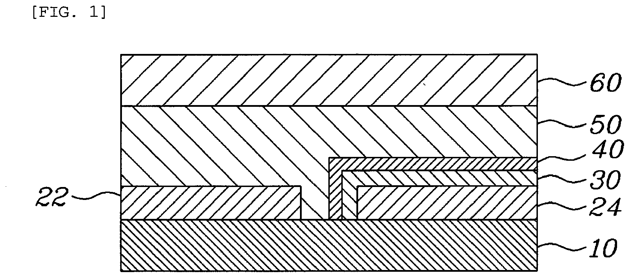

Referring to FIG. 1, the CIS/CIGS-based solar cell according to an embodiment of the present invention includes a substrate 10, first and second molybdenum electrodes 22 and 24, a TCO layer 30, a buffer layer 40, a light-absorbing layer 50 and an antireflection layer 60, which are sequentially layered from the bottom thereof. Here, the TCO layer 30 and the buffer layer 40 are sequentially disposed on the upper and lateral sides of the second molybdenum electrode 24 to be disposed on the substrate 10 in parallel with each other and spaced apart from the first molybdenum electrode 22. Hereinafter, the structure of the CIS/CIGS-based solar cell will be described in detail.

The substrate 10 is a plated structure on which components of a solar cell are disposed and which serves to support the components thereof. Preferably, the substrate is made of glass, but, if necessary, may be made of stainless steel, polyimide or the like.

The first molybdenum electrode 22 and the second molybdenum electrode 24 are disposed on the substrate 10 in parallel with each other at a predetermined interval. In this case, the first molybdenum electrode 22 corresponds to a rear electrode of a general thin film solar cell, and the second molybdenum electrode 24 corresponds to a front metal electrode thereof.

The TCO layer 30 is a transparent conducting layer, and is disposed on the upper and lateral sides of the second molybdenum electrode 24 to cover the second molybdenum electrode 24. Therefore, the first molybdenum electrode 22 and the TCO layer 30 are disposed on the substrate 10 in parallel with each other with the light-absorbing layer 50 being disposed therebetween.

In this case, the TCO layer 30 consists of a lower layer and an upper layer. The lower layer is an N-type transparent conducting film, and the upper layer is an I-type transparent conducting film. The lower and upper layers can constitute a PIN junction together with the light-absorbing layer 50.

Here, the TCO layer 30 may be made of a transparent material having electrical conductivity, such as zinc oxide (ZnO), indium tin oxide (ITO) or the like.

The buffer layer 40 functions to reduce the increase in bandgap between the TCO layer 30 and the light-absorbing layer 50. The buffer layer 40 is disposed on the upper and lateral sides of the TCO layer 30 to cover the TCO layer 30. It is preferred that the buffer layer 40 be made of cadmium sulfide (CdS). The buffer layer 40 may also be made of an alternative material such as zinc sulfide (ZnS), indium sulfide (In₂S₃) or the like.

The light-absorbing layer 50 is disposed over the first molybdenum electrode 22, the buffer layer 40 and the substrate exposed between the first molybdenum electrode 22 and the buffer layer 40.

The light-absorbing layer 50 may be made of a CIS-based compound or a CIGS-based compound. Specifically, the light-absorbing layer 50 may include: ternary compounds such as Cu-InS, Cu-Ga-S, Cu-Ga-Se and the like; quaternary compounds such as Cu-In-Ga-Se and the like; and 5-component and 6-component compounds such as Cu-In-Ga-Se-(S,Se), Cu-In-Al-Ga-(S,Se), Cu-In-Al-Ga-Se-S and the like. These compounds are based on Cu-In-Se which is an IB-IIIA-VIA group semiconductor.

Moreover, the light-absorbing layer 50 may further include a CZTS-based compound. The CZTS-based compound may include Cu-Zn-Sn-(Se,S) obtained by substituting all IIIA group elements (In, Ga, Al, etc.) with IIB group elements (Zn, etc.) and IVA group elements (Sn, etc.) and Cu-In-Ga-Zn-Sn-(Se,S) obtained by substituting some of IIIA group elements (In, Ga, Al, etc.) with IIB group elements (Zn, etc.) and IVA group elements (Sn, etc.)

The antireflection layer 60 is disposed on the light-absorbing layer, and is provided as a double layer including a lower alumina (Al₂O₃) layer in contact with the light-absorbing layer 50 and an upper magnesium fluoride (MgF₂) layer directly exposed to the air.

Therefore, the CIS/CIGS-base solar cell of the present invention is advantageous in that the problem of deterioration of light absorptivity occurring when the TCO layer 30 and the buffer layer 40 is disposed at the front of the solar cell can be solved because they are disposed under the light-absorbing layer 50.

The present invention provides a solar cell module including the CIS/CIGS-based solar cell.

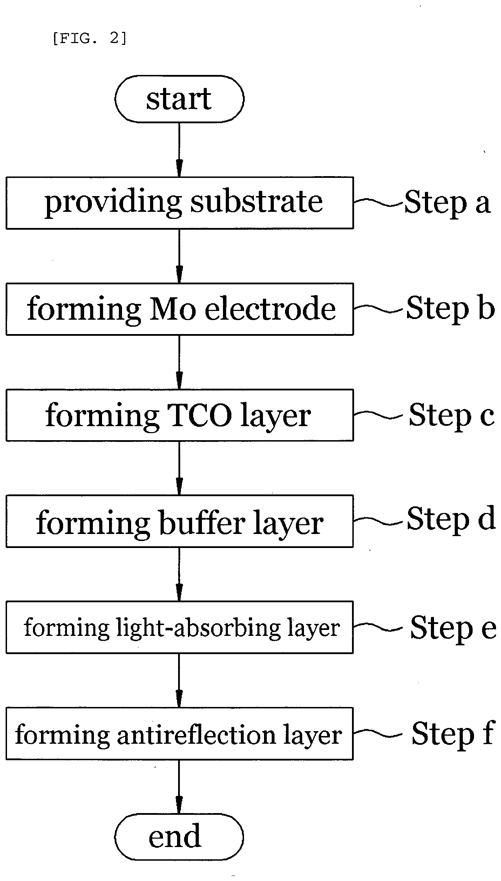

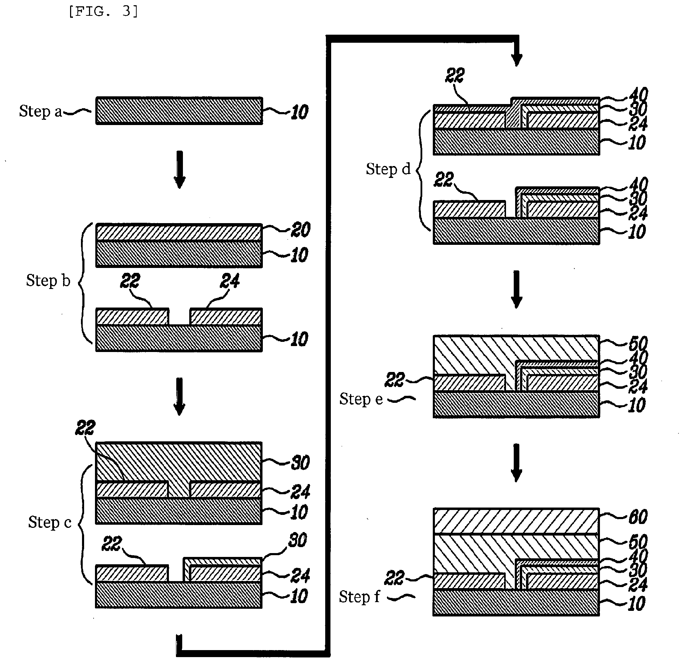

FIG. 2 is a flowchart showing a method of manufacturing a CIS/CIGS-based solar cell according to the present invention, and FIG. 3 is a process view schematically showing the method of FIG. 2

Hereinafter, the method of manufacturing a CIS/CIGS-based solar cell according to the present invention will be described with reference to FIGS. 2 and 3.

First, a plated substrate 10 is provided (step a).

As described in the structure of the CIS/CIGS solar cell, the substrate may be made of glass, stainless steel or polyimide, and preferably glass.

The substrate may be sequentially washed with acetone, methanol and distilled water, and then ultrasonically treated.

Thereafter, first and second molybdenum electrodes 22 and 24 are formed on the substrate (step b).

The first and second molybdenum electrodes 22 and 24 are formed by depositing a molybdenum layer 20 on the substrate 10 and then patterning the molybdenum layer 20. Specifically, the deposition of the molybdenum layer 10 may is preformed by sputtering. That is, the molybdenum layer 20 may be formed by performing a sputtering process for 1 ∼ 30 minutes under the conditions of a power of 0.5 ∼ 50 kW, a sputtering pressure of 0.1 ∼ 50 m Torr and an argon (Ar) gas supply of 1 ∼ 100 sccm.

The deposited molybdenum layer 20, as shown in FIG. 3, is separated into the first molybdenum electrode 22 and the second molybdenum electrode 24 by patterning. The first molybdenum electrode 22 and the second molybdenum electrode 24 are disposed at a predetermined interval, and the substrate 10 is exposed by the interval.

The patterning of the molybdenum layer 10 may be performed by laser scribing. The laser scribing may be performed under the conditions of a laser wavelength of 300 ∼ 1100 nm and a laser power of 0.3 ∼ 3 W.

Subsequently, a TCO layer 30 is formed (step c).

Specifically, an N-type transparent conducting film and an I-type transparent conducting film are sequentially deposited and patterned on the substrate 10 provided with the first and second molybdenum electrodes 22 and 24 to form a double TCO layer 30. Here, each of the N-type and I-type transparent conducting films may be made of zinc oxide, and, if necessary, may be made of ITO.

The deposition of each of the N-type and I-type transparent conducting films may be performed by sputtering.

In this case, the N-type transparent conducting film may be formed by performing a sputtering process for 10 ∼ 100 minutes under the conditions of a power of 50 ∼ 500 W, a sputtering pressure of 1 ∼ 50 m Torr, an argon gas supply of 10 ∼ 100 sccm and an oxygen gas supply of 0.5 ∼ 10 sccm.

Further, the I-type transparent conducting film may be formed by performing a sputtering process for 10 ∼ 100 minutes under the conditions of a power of 50 ∼ 500 W, a sputtering pressure of 1 ∼ 50 m Torr and an argon gas supply of 10 ∼ 100 sccm.

The N-type and I-type transparent conducting films are sequentially sputtering-deposited and patterned to allow the double TCO layer 30 to be disposed on the upper and lateral sides of the second molybdenum electrode 24 such that the second molybdenum electrode 24 is covered by the double TCO layer 30. Therefore, as shown in FIG. 3, the double TCO layer 30 and the first molybdenum electrode 22 may be provided on the substrate 10 in parallel with each other at a predetermined interval.

The pattering of each of the N-type and I-type transparent conducting films may be performed by laser scribing. The laser scribing may be performed under the conditions of a laser wavelength of 300 ∼ 1100 nm and a laser power of 0.3 ∼ 3 W.

Subsequently, a buffer layer 40 is formed (step d).

Specifically, the buffer layer 40 may be formed by immersing the substrate 10 provided with the first and second molybdenum electrodes 22 and 24 and the TCO layer into a mixed solution including thiourea, cadmium sulfide and ammonia at a temperature of 60 ∼ 100°C for 10 ∼ 100 minutes. If necessary, an alternative material such as zinc sulfide, indium sulfide or the like may be used instead of cadmium sulfide.

Then, the formed buffer layer 40 is patterned such that the buffer layer 40 is spaced apart from the first molybdenum electrode 22 and is disposed on only the upper and lateral sides of the TCO layer 30. The patterning of the buffer layer 40 may be performed by laser scribing. The laser scribing may be performed under the conditions of a laser wavelength of 300 ∼ 600 nm and a laser power of 0.3 ∼ 3 W.

Subsequently, a light-absorbing layer 50 is formed on the substrate having passed the step d) (step e).

The light-absorbing layer 50 is made of a CIS-based or CIGS-based compound. Since the CIS-based and CIGS-based compounds were afore-mentioned in the structure of the CIS/CIGS-base solar cell of the present invention, description thereof will be omitted.

The formation of the light-absorbing layer 50 may be preformed by non-vacuum coating or vacuum coating. As the non-vacuum coating, various types of coating methods commonly known in the related field, such as spraying, ultrasonic spraying, spin coating, a doctor blade method, screen printing and ink-jet printing and the like may be used.

Further, as the vacuum coating, simultaneous vacuum evaporation, sputtering/selenization, three-stage simultaneous vacuum evaporation or the like may be used.

Here, the simultaneous vacuum evaporation is a process of simultaneously evaporating Cu, In, Ga and Se as starting materials, and the sputtering/selenization is a process of simultaneously sputtering Cu, In, Ga and the like to form a precursor layer and then heat-treating the precursor layer with selenium under a selenium (Sn) atmosphere. Further, the three-stage simultaneous vacuum evaporation is a process of evaporating In, Ga and Se at low substrate temperature to form a precursor, supplying Cu to the precursor and then supplying In and Ga to the precursor.

This light-absorbing layer 50 is formed such that it entirely covers the substrate 10 provided thereon with the first molybdenum electrode 22 and the buffer layer 40.

Finally, an antireflection layer 60 is formed on the light-absorbing layer 50 (step f).

In this case, the antireflection layer is formed by sequentially forming a lower alumina layer and an upper magnesium fluoride layer.

The alumina layer may be formed by performing ALD (atomic layer deposition) using gas produced by the reaction of trimethyl aluminum (Al(CH)₃) and ozone (O₃).

Further, the magnesium fluoride layer may be formed by performing thermal evaporation using magnesium fluoride pellets.

Hereinafter, the method of manufacturing a CIS/CIGS-based solar cell according to the present invention will be described in detail with reference to the following Example.

### <Example 1>

A glass substrate having a thickness of 1.1 mm and a size of 10 X 10 cm² was sequentially washed with acetone, methanol and distilled water, and was then ultrasonically treated for 15 minutes.

Thereafter, molybdenum was deposited on the glass substrate for 10 minutes by sputtering under the conditions of a power of 1.4 kW, a sputtering pressure of 10 m Torr, an argon gas supply of 40 sccm to form a molybdenum electrode layer having a thickness of 2 *µ*m. Subsequently, the molybdenum electrode layer was patterned by laser scribing under the conditions of a laser wavelength of 1064 nm and a laser power of 3 W to be separated into a first molybdenum electrode and a second molybdenum electrode. The remaining portion of the molybdenum electrode layer was disposed such that the glass substrate was exposed.

Subsequently, N-type zinc oxide and I-type zinc oxide were sequentially sputtered and scribed on the glass substrate provided with the molybdenum electrode layer to form a double TCO layer on the exposed surface of the second molybdenum electrode

The N-type zinc oxide film was formed to a thickness of 0.7 *µ*m by sputtering N-type zinc oxide for 45 minutes under the conditions of a power of 50 W, a sputtering pressure of 10 m Torr, an argon gas supply of 40 sccm and an oxygen gas supply of 5 sccm. Thereafter, this N-type zinc oxide film was laser-scribed under the conditions of a laser wavelength of 1064 nm and a laser power of 1 W to be patterned such that it is spaced apart from the first molybdenum electrode and covers only the surface of the second molybdenum electrode.

The I-type zinc oxide film was formed to a thickness of 0.05 *µ*m by sputtering I-type zinc oxide for 40 minutes under the conditions of a power of 400 W, a sputtering pressure of 1 m Torr and an argon gas supply of 40 sccm. Thereafter, this I-type zinc oxide film was laser-scribed under the conditions of a laser wavelength of 1064 nm and a laser power of 1 W to be patterned such that it covers the upper and lateral surfaces of the N-type zinc oxide film spaced apart from the first molybdenum electrode and covering the upper and lateral surfaces of the second molybdenum electrode.

Subsequently, the glass substrate provided with the exposed first molybdenum electrode and TCO layer was immersed into a mixed solution including thiourea, cadmium sulfide and ammonia at a temperature of 80°C for 15 minutes to form a cadmium sulfide buffer layer, and then this buffer layer was laser-scribed under the conditions of a laser wavelength of 532 nm and a laser power of 0.3 W to be patterned such that it is spaced apart from the first molybdenum electrode and is disposed only the upper and lateral surfaces of the TCO layer.

Thereafter, the substrate having passed through the above processes was coated with a solution including Cu, In, Ga and Se nanoparticles by a doctor blade method, and was then heat-treated to form a light-absorbing layer. The light-absorbing layer covers the first molybdenum electrode, the buffer layer and the substrate exposed between the first molybdenum electrode and the buffer layer.

Finally, an alumina layer was formed on the light-absorbing layer by performing atomic layer deposition (ALD) using gas produced by the reaction of trimethyl aluminum and ozone, and then a magnesium fluoride layer was formed by thermal evaporation using magnesium fluoride pellets.

Although the preferred embodiments of the present invention have been disclosed for illustrative purposes, those skilled in the art will appreciate that various modifications, additions and substitutions are possible, without departing from the scope of the invention as disclosed in the accompanying claims.

For example, although an embodiment of the present invention is configured such that a TCO layer and a buffer layer is formed on a second molybdenum electrode, this configuration is devised to meet the convenience of explaining the structure of the solar cell of the present invention, the TCO layer and buffer layer may be disposed on any one of molybdenum electrodes, and the arrangement of the molybdenum electrodes may be performed in various manners within the scope of the present invention.

## Claims

1. A CIS/CIGS-based solar cell, comprising:
a substrate (10);
first and second molybdenum electrodes (22, 24) disposed on the substrate (10) at a predetermined interval in parallel with each other;
a TCO layer (30) disposed on upper and lateral sides of the second molybdenum electrode (24);
a buffer layer (40) disposed on upper and lateral sides of the TCO layer (30) to compensate for a difference in bandgap between the TCO layer (30) and a light-absorbing layer (50);
the light-absorbing layer (50) disposed on the first molybdenum electrode (22), the buffer layer (40) and an area of the substrate (10) partially opened between the first molybdenum electrode (22) and the buffer layer (40); and
an antireflection layer (60) disposed on the light-absorbing layer (50) to minimize the reflection of externally-applied light,
wherein the light-absorbing layer (50) is made of any one CIS/CIGS-based compound selected from the group consisting of Cu-In-Se, Cu-In-S, Cu-Ga-S, Cu-Ga-Se, Cu-In-Ga-Se, Cu-In-Ga-Se-(S,Se), Cu-In-Al-Ga-(S,Se) and Cu-In-Al-Ga-Se-S, or is made of any one CZTS-based compound selected from the group consisting of Cu-Zn-Sn-(Se,S) and Cu-In-Ga-Zn-Sn-(Se,S).

2. The CIS/CIGS-based solar cell of claim 1, wherein the TCO layer (30) includes an N-type lower transparent conducting film and an I-type upper transparent conducting film.

3. A method of manufacturing a CIS/CIGS-based solar cell, comprising the steps of:
a) providing a substrate (10);
b) depositing a molybdenum layer on the substrate and then patterning the molybdenum layer to form first and second molybdenum electrodes (22, 24) disposed on the substrate (10) at a predetermined interval in parallel with each other;
c) depositing a TCO layer (30) on the substrate (10) having passed through the step b) and then patterning the TCO layer (30) to form a TCO layer (30) disposed on upper and lateral sides of the second molybdenum electrode (24);
d) depositing a buffer layer (40) on the substrate (10) having passed through the step c) and then patterning the buffer layer (40) to form a buffer layer (40) disposed on upper and lateral sides of the TCO layer (30);
e) forming a light-absorbing layer (50) on the substrate (10) having passed through the step d), wherein the light-absorbing layer (50) is made of any one CIS/CIGS-based compound selected from the group consisting of Cu-In-Se, Cu-In-S, Cu-Ga-S, Cu-Ga-Se, Cu-In-Ga-Se, Cu-In-Ga-Se-(S,Se), Cu-In-Al-Ga-(S,Se) and Cu-In-Al-Ga-Se-S, or is made of any one CZTS-based compound selected from the group consisting of Cu-Zn-Sn-(Se,S) and Cu-In-Ga-Zn-Sn-(Se,S); and
f) forming an antireflection layer (60) on the light-absorbing layer (50).

4. The method of claim 3, wherein the deposition of the molybdenum layer using sputtering is performed for 1 ∼ 30 minutes under the conditions of a power of 0.5 ∼ 50 kW, a sputtering pressure of 0.1 ∼ 50 m Torr and an argon (Ar) gas supply of 1 ∼ 100 sccm.

5. The method of claim 3, wherein, in the step c), the TCO layer (30) is formed such a way that an N-type transparent conducting film is deposited and patterned, and then an I-type transparent conducting film is deposited and patterned to form a double TCO layer (30).

6. The method of claim 5, wherein the N-type transparent conducting film and the I-type transparent conducting film are deposited by sputtering,
the deposition of the N-type transparent conducting film using sputtering is performed for 10 ∼ 100 minutes under the conditions of a power of 50 ∼ 500 W, a sputtering pressure of 1 ∼ 50 m Torr, an argon gas supply of 10 ∼ 100 sccm and an oxygen gas supply of 0.5 ∼ 10 sccm, and
the deposition of the I-type transparent conducting film using sputtering is performed for 10 ∼ 100 minutes under the conditions of a power of 50 ∼ 500 W, a sputtering pressure of 1 ∼ 50 m Torr and an argon gas supply of 10 ∼ 100 sccm.

7. The method of claim 3, wherein, in the step d), the buffer layer (40) is formed by immersing the substrate (10) having passed through the step c) into a mixed solution including thiourea, cadmium sulfide and ammonia.

8. The method of claim 7, wherein the buffer layer (40) is formed by immersing the substrate (10) into the mixed solution at a temperature of 60 ∼ 100°C for 10 ∼ 100 minutes.

9. The method of claim 3, wherein, in the step e), the formation of the light-absorbing layer (50) is preformed by non-vacuum coating or vacuum coating.

10. The method of claim 9, wherein the non-vacuum coating is any one selected from among spraying, ultrasonic spraying, spin coating, a doctor blade method, screen printing and ink-jet printing.

11. The method of claim 9, wherein the vacuum coating is any one selected from among simultaneous vacuum evaporation, sputtering/selenization and three-stage simultaneous vacuum evaporation.

12. The method of claim 3, wherein, in the step f), the antireflection layer is formed by sequentially forming a lower alumina layer and an upper magnesium fluoride layer.

13. The method of claim 12, wherein the formation of the alumina layer is performed by atomic layer deposition (ALD) using gas produced by the reaction of trimethyl aluminum and ozone.

14. A solar cell module comprising a CIS/CIGS solar cell according to any one of claims 1 or 2.

## Patentansprüche

1. Eine CIS/CIGS-basierte Solarzelle, umfassend:
ein Substrat (10);
eine erste und eine zweite Molybdänelektrode (22, 24), die auf dem Substrat (10) in einem vorbestimmten Intervall parallel zueinander angeordnet sind;
eine TCO-Schicht (30), die auf der oberen und einer lateralen Seite der zweiten Molybdänelektrode (24) angeordnet ist;
eine Pufferschicht (40), die auf der oberen und einer lateralen Seite der TCO-Schicht (30) angeordnet ist, um einen Bandlückenunterschied zwischen der TCO-Schicht (30) und einer lichtabsorbierenden Schicht (50) auszugleichen;
die lichtabsorbierende Schicht (50), die auf der ersten Molybdänelektrode (22) angeordnet ist, die Pufferschicht (40) und eine Fläche des Substrats (10), die teilweise zwischen der ersten Molybdänelektrode (22) und der Pufferschicht (40) geöffnet ist; und
eine Antireflexionsschicht (60), die auf der lichtabsorbierenden Schicht (50) angeordnet ist, um die Reflexion von extern angelegtem Licht zu minimieren, wobei die lichtabsorbierende Schicht (50) aus einer beliebigen CIS/CIGSbasierten Verbindung hergestellt ist, die aus der Gruppe bestehend aus Cu-In-Se, Cu-In-S, Cu-Ga-S, Cu-Ga-Se, Cu-In-Ga-Se, Cu-In-Ga-Se-(S,Se), Cu-In-AI-Ga-(S,Se) und Cu-In-Al-Ga-Se-S ausgewählt ist, oder aus einer beliebigen CZTS-basierten Verbindung hergestellt ist, die aus der Gruppe bestehend aus Cu-Zn-Sn-(Se,S) und Cu-In-Ga-Zn-Sn-(Se,S) ausgewählt ist.

2. CIS/CIGS-basierte Solarzelle nach Anspruch 1, wobei die TCO-Schicht (30) einen unteren transparenten leitenden Film vom N-Typ und einen oberen transparenten leitenden Film vom I-Typ aufweist.

3. Verfahren zur Herstellung einer CIS/CIGS-basierten Solarzelle, umfassend die Schritte:
a) Bereitstellen eines Substrats (10);
b) Abscheiden einer Molybdänschicht auf dem Substrat und dann Strukturieren der Molybdänschicht, um eine erste und eine zweite Molybdänelektrode (22, 24) zu bilden, die auf dem Substrat (10) in einem vorbestimmten Intervall parallel zueinander angeordnet sind;
c) Abscheiden einer TCO-Schicht (30) auf dem Substrat (10), das den Schritt b) durchlaufen hat, und dann Strukturieren der TCO-Schicht (30), um eine TCO-Schicht (30) zu bilden, die auf der oberen und einer lateralen Seite der zweiten Molybdänelektrode (24) angeordnet ist;
d) Abscheiden einer Pufferschicht (40) auf dem Substrat (10), das den Schritt c) durchlaufen hat, und dann Strukturieren der Pufferschicht (40), um eine Pufferschicht (40) zu bilden, die auf der oberen und einer seitlichen Fläche der TCO-Schicht (30) angeordnet ist;
e) Bilden einer lichtabsorbierenden Schicht (50) auf dem Substrat (10), das den Schritt d) durchlaufen hat, wobei die lichtabsorbierende Schicht (50) aus einer beliebigen CIS/CIGS-basierten Verbindung hergestellt ist, die aus der Gruppe bestehend aus Cu-In-Se, Cu-In-S, Cu-Ga-S, Cu-Ga-Se, Cu-In-Ga-Se, Cu-In-Ga-Se-(S,Se), Cu-In-Al-Ga-(S,Se) und Cu-In-Al-Ga-Se-S ausgewählt ist, oder aus beliebigen CZTS-basierten Verbindung hergestellt ist, die aus der Gruppe bestehend aus Cu-Zn-Sn-(Se,S) und Cu-In-Ga-Zn-Sn-(Se,S) ausgewählt ist; und
f) Bilden einer Antireflexschicht (60) auf der lichtabsorbierenden Schicht (50).

4. Verfahren nach Anspruch 3, wobei die Abscheidung der Molybdänschicht unter Verwendung von Sputtern für 1 bis 30 Minuten unter den Bedingungen einer Leistung von 0,5 bis 50 kW, eines Sputterdrucks von 0,1 bis 50 mTorr und einer Argongaszufuhr (Ar) von 1 bis 100 sccm durchgeführt wird.

5. Verfahren nach Anspruch 3, wobei in dem Schritt c) die TCO-Schicht (30) derart gebildet wird, dass ein transparenter leitender Film vom N-Typ abgeschieden und strukturiert wird, und dann ein transparenter leitender Film vom I-Typ abgeschieden und strukturiert wird, um eine doppelte TCO-Schicht (30) zu bilden.

6. Verfahren nach Anspruch 5, wobei der transparente leitende Film vom N-Typ und der transparente leitende Film vom I-Typ durch Sputtern abgeschieden werden, wobei die Abscheidung des transparenten leitenden Films vom N-Typ unter Verwendung von Sputtern für 10 bis 100 Minuten unter den Bedingungen einer Leistung von 50 bis 500 W, eines Sputterdruckes von 1 bis 50 mTorr, einer Argongaszufuhr (Ar) von 10 bis 100 sccm und einer Sauerstoffgaszufuhr von 0,5 bis 10 sccm, und
die Abscheidung des transparenten leitenden Films vom I-Typ unter Verwendung von Sputtern für 10 bis 100 Minuten lang unter den Bedingungen einer Leistung von 50 bis 500 W, eines Sputterdruckes von 1 bis 50 mTorr und einer Argongaszufuhr (Ar) von 10 bis 100 sccm durchgeführt.

7. Verfahren nach Anspruch 3, wobei in Schritt d) die Pufferschicht (40) durch Eintauchen des Substrats (10), das den Schritt c) durchlaufen hat, in eine gemischte Lösung, die Thioharnstoff, Cadmiumsulfid und Ammoniak enthält, gebildet wird.

8. Verfahren nach Anspruch 7, wobei die Pufferschicht (40) durch Eintauchen des Substrats (10) in die gemischte Lösung bei einer Temperatur von 60 bis 100 °C für 10 bis 100 Minuten gebildet wird.

9. Verfahren nach Anspruch 3, wobei in Schritt e) die Bildung der lichtabsorbierenden Schicht (50) durch Nicht-Vakuumbeschichtung oder Vakuumbeschichtung durchgeführt wird.

10. Verfahren nach Anspruch 9, wobei die Nicht-Vakuumbeschichtung ausgewählt ist aus Sprühen, Ultraschallsprühen, Schleuderbeschichtung, Rakelverfahren, Siebdruck und Tintenstrahldrucken.

11. Verfahren nach Anspruch 9, wobei die Vakuumbeschichtung ausgewählt ist aus simultaner Vakuumverdampfung, Sputtern/Selenisierung und dreistufiger simultaner Vakuumverdampfung.

12. Verfahren nach Anspruch 3, wobei in Schritt f) die Antireflexionsschicht durch aufeinanderfolgendes Bilden einer unteren Aluminiumoxidschicht und einer oberen Magnesiumfluoridschicht gebildet wird.

13. Verfahren nach Anspruch 12, wobei die Bildung der Aluminiumoxidschicht durch Atomlagenabscheidung (ALD) unter Verwendung von Gas, das durch die Reaktion von Trimethylaluminium und Ozon erzeugt wird, durchgeführt wird.

14. Solarzellenmodul, umfassend eine CIS/CIGS-Solarzelle gemäß einem der Ansprüche 1 oder 2.

## Revendications

1. Cellule photovoltaïque CIS/CIGS, comprenant :
un substrat (10) ;
une première et une deuxième électrodes en molybdène (22, 24) disposes sur le substrat (10) à intervalle défini parallèlement l'une à l'autre ;
une couche d'OCT (30) disposée sur la surface supérieure et une surface latérale de la deuxième électrode en molybdène (24) ;
une couche tampon (40) disposée sur la surface supérieure et une surface latérale de la couche d'OCT (30) pour compenser une différence de bande interdite entre la couche d'OCT (30) et une couche absorbant la lumière (50) ;
la couche absorbant la lumière (50) étant disposée sur la première électrode en molybdène (22), la couche tampon (40) et une surface du substrat (10) étant partiellement exposées entre la première électrode en molybdène (22) et
la couche tampon (40) ; et
une couche antireflet (60) disposée sur la couche absorbant la lumière (50) pour minimiser la réflexion de lumière extérieure appliquée,
la couche absorbant la lumière (50) étant constituée d'un composé CIS/CIGS quelconque sélectionné dans le groupe comprenant Cu-In-Se, Cu-In-S, Cu-Ga-S, Cu-Ga-Se, Cu-In-Ga-Se, Cu-In-Ga-Se-(S,Se), Cu-In-Al-Ga-(S,Se) et Cu-InAl-Ga-Se-S, ou d'un composé CZTS quelconque sélectionné dans le groupe comprenant Cu-Zn-Sn-(Se,S) et Cu-In-Ga-Zn-Sn-(Se,S).

2. Cellule photovoltaïque CIS/CIGS selon la revendication 1, où la couche d'OCT (30) comprend un film conducteur transparent inférieur de type N et un film conducteur transparent supérieur de type I.

3. Procédé de fabrication d'une cellule photovoltaïque CIS/CIGS, comprenant les étapes suivantes :
a) préparation d'un substrat (10) ;
b) dépôt d'une couche de molybdène sur le substrat, puis structuration de la couche de molybdène pour former une première et une deuxième électrodes en molybdène (22, 24) disposées sur le substrat (10) à intervalle défini parallèlement l'une à l'autre ;
c) dépôt d'une couche d'OCT (30) sur le substrat (10) ayant été soumis à l'étape b), puis structuration de la couche d'OCT (30) pour former une couche d'OCT (30) disposée sur la surface supérieure et une surface latérale de la deuxième électrode en molybdène (24) ;
d) dépôt d'une couche tampon (40) sur le substrat (10) ayant été soumis à l'étape c), puis structuration de la couche tampon (40) pour former une couche tampon (40) disposée sur la surface supérieure et une surface latérale de la couche d'OCT (30) ;
e) formation d'une couche absorbant la lumière (50) sur le substrat (10) ayant été soumis à l'étape d), la couche absorbant la lumière (50) étant constituée d'un composé CIS/CIGS quelconque sélectionné dans le groupe comprenant Cu-In-Se, Cu-In-S, Cu-Ga-S, Cu-Ga-Se, Cu-In-Ga-Se, Cu-In-Ga-Se-(S,Se), Cu-In-Al-Ga-(S,Se) et Cu-InAl-Ga-Se-S, ou d'un composé CZTS quelconque sélectionné dans le groupe comprenant Cu-Zn-Sn-(Se,S) et Cu-In-Ga-Zn-Sn-(Se,S) ; et
f) formation d'une couche antireflet (60) sur la couche absorbant la lumière (50).

4. Procédé selon la revendication 3, où le dépôt de la couche de molybdène par pulvérisation est effectué pendant 1 ∼ 30 minutes sous les conditions d'un courant de 0,5 ∼ 50 kW, d'une pression de pulvérisation de 0,1 ∼ 50 mTorr et d'une alimentation en gaz argon (Ar) de 1 ∼ 100 sccm.

5. Procédé selon la revendication 3, où, lors de l'étape c), la couche d'OCT (30) est formée de sorte qu'un film conducteur transparent de type N est déposé et structuré, avant dépôt d'un film conducteur transparent de type I et structuration de celui-ci pour former une double couche d'OCT (30).

6. Procédé selon la revendication 5, où le film conducteur transparent de type N et le film conducteur transparent de type I sont déposés par pulvérisation, le dépôt du film conducteur transparent de type N par pulvérisation étant effectué pendant 10 ∼ 100 minutes sous les conditions d'un courant de 50 ∼ 500 kW, d'une pression de pulvérisation de 1 ∼ 50 mTorr, d'une alimentation en gaz argon (Ar) de 10 ∼ 100 sccm et d'une alimentation en gaz oxygène de 0,5 ∼ 10 sccm, et
le dépôt du film conducteur transparent de type I par pulvérisation étant effectué pendant 10 ∼ 100 minutes sous les conditions d'un courant de 50 ∼ 500 W, d'une pression de pulvérisation de 1 ∼ 50 m Torr et d'une alimentation en gaz argon (Ar) de 10 ∼ 100 sccm.

7. Procédé selon la revendication 3, où, lors de l'étape d), la couche tampon (40) est formée par immersion du substrat (10) ayant été soumis à l'étape c) dans une solution mixte comprenant dioxyde de thiourée, sulfure de cadmium et ammoniac.

8. Procédé selon la revendication 7, où la couche tampon (40) est formée par immersion du substrat (10) dans la solution mixte à température de 60 ∼ 100°C pendant 10 ∼ 100 minutes.

9. Procédé selon la revendication 3, où, lors de l'étape e), la formation de la couche absorbant la lumière (50) est obtenue par revêtement sous vide ou par revêtement sans vide.

10. Procédé selon la revendication 9, où le revêtement sans vide est sélectionné parmi pulvérisation, pulvérisation à ultrasons, enduction centrifuge, procédé à racloir, sérigraphie et impression par jet d'encre.

11. Procédé selon la revendication 9, où le revêtement sous vide est sélectionné parmi évaporation simultanée sous vide, pulvérisation/sélénisation et évaporation simultanée sous vide à trois effets.

12. Procédé selon la revendication 3, où, lors de l'étape f), la couche antireflet est formée par formation séquentielle d'une couche d'alumine inférieure et d'une couche de fluorure de magnésium supérieure.

13. Procédé selon la revendication 12, où la formation de la couche d'alumine est obtenue par dépôt par couche atomique (ALD) au moyen du gaz généré par la réaction de triméthyl-aluminium et d'ozone.

14. Module de cellule photovoltaïque comprenant une cellule photovoltaïque CIS/CIGS selon la revendication 1 ou la revendication 2.
